# EUROPÄISCHE PATENTSCHRIFT

(11) **EP 0 809 321 B1**
(45) Veröffentlichungstag und Bekanntmachung des Hinweises auf die Patenterteilung: **24.02.1999**
(21) Anmeldenummer: 97107649.2
(22) Anmeldetag: 09.05.1997
(51) Int. Cl.: H01Q 1/20, H01Q 1/28, H03H 7/40, H03H 7/42, G01R 27/06

(54) **Symmetrierendes Antennenanpassgerät**
Balancing antenna matching circuit
Circuit d'équilibrage d'adaptation d'antenne

(30) Priorität: 21.05.1996 DE 19620333
(43) Veröffentlichungstag der Anmeldung: 26.11.1997
(73) Patentinhaber: Daimler-Benz Aerospace AG, 81663 München (DE)
(72) Erfinder: Kombrink, Friedemann, 89129 Langenau (DE)
(74) Vertreter: Fröhling, Werner Otto, Dr.

(56) Entgegenhaltungen:
- EP-A- 0 685 936
- WO-A-88/05214
- DD-A- 120 977
- DE-A- 4 441 754
- US-A- 4 612 669
- US-A- 5 068 672

## Beschreibung

Die Erfindung betrifft ein symmetrierendes Antennenanpaßgerät für Kurzwellen-Dipole gemäß dem Oberbegriff des Patentanspruchs 1.

Für die Symmetrierung von Antennenhälften zur unsymmetrischen Speiseleitung ist im Kurzwellenbereich die Verwendung von Balun-Transformatoren bekannt. Der Einsatz dieser bekannten Symmetriertransformatoren ist bei Breitband-Antennenhälften möglich, die eine starke Bedämpfung aufweisen, wobei der Wert für das Stehwellenverhältnis maximal im Bereich von 2,5 bis 3 liegt. Für Antennenhälften, deren Abmessung nur ein Bruchteil der Wellenlänge beträgt und die deshalb eine sehr hohe Güte aufweisen, sind die bekannten Symmetriertransformatoren nicht einsetzbar. Bei derartig kleinen Antennenhälften treten große Symmetriefehler auf, da die Güte der Antenne viel größer ist als der Kehrwert der Bauteiltoleranzen. Je kürzer die Dipole und je höher damit die erforderlichen Antennenspannungen sind, um ausreichende Abstrahlungsleistungen zu erzielen, desto länger müssen die Windungsleitungen der Symmetriertransformatoren sein, damit ihre Ferritkerne nicht übersteuert werden. Diese langen Windungsleitungen sind bedämpft und zudem extrem fehlangepaßt, da Antennen mit diesen kleinen Abmessungen die Speiseleitungen mit einem Stehwellenverhältnis abschließen, das nahezu unendlich groß ist. Die Verwendung von Balun-Transformatoren würde deshalb für diesen Anwendungsfall mit großen Leistungsverlusten verbunden sein.

Weiterhin sind für alle Arten von Kurzwellenantennen Anpaßgeräte bekannt, die über ein am Einspeisungspunkt der Antenne in die Antennenleitung integriertes steuerbares Anpaßnetzwerk eine Transformation der Antennenimdepanz auf Reflexionsminimum gegenüber dem Lastwiderstand der Sender-Empfänger-Stufe bewirken.

Aufgabe der Erfindung ist es, ein Verfahren für die Anpassung und gleichzeitige Symmetrierung von getrennten Kurzwellen-Dipolhälften zu schaffen, deren Abmessung ein Bruchteil der Wellenlänge beträgt.

Diese Aufgabe wird erfindungsgemäß durch die Merkmale des Patentanspruchs 1 gelöst. Weiterbildungen sind in den Unteransprüchen angegeben.

Die Erfindung hat den Vorteil, daß eine gemeinsame, gleichzeitige Abstimmung beider Antennenhälften auf das Reflexionsminimum bei gleichzeitiger Symmetrierung der Leistungsabstrahlung beider Antennenhälften erreicht ist. Die Symmetrierung wirkt sich nicht nur vorteilhaft auf die Strahlungsleistung der Dipolhälften selbst aus, sondern unterdrückt auch konjugiert komplexe Reflexionen, die trotz einer Anpassung auf Reflexionsminimum bei fehlender Symmetrierung auf den beiden Speiseleitungen auftreten würden.

Anhand der Zeichnung ist ein Ausführungsbeispiel der Erfindung näher erläutert.
Fig. 1 zeigt ein Blockschaltbild eines Antennenanpassungsgeräts und die Anordnung von Dipolhälften in einem Flugkörper und
Fig. 2 zeigt ein detailliertes Blockschaltbild des Geräts.

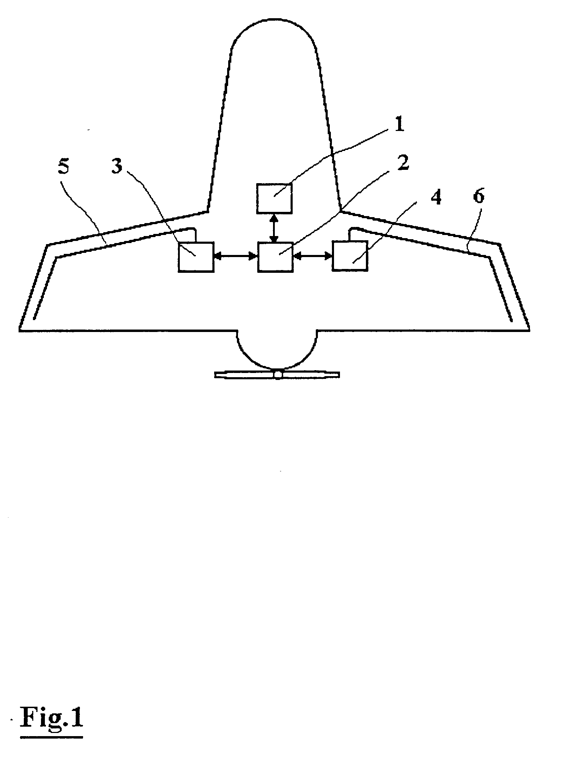

Fig. 1 zeigt einen Flugkörper mit einer Sender-Empfänger-Stufe 1, einem Antennenanpaßgerät 2, zwei getrennten Dipolhälften 5 und 6 für den Kurzwellenbereich und mit je einem Anpaßnetzwerk 3 und 4 für jede der Dipolhälften.

Die Dipolhälften sind in ihren Abmessungen durch den Flugkörper derart begrenzt, daß diese nur einen Bruchteil der zu übertragenden Wellenlänge betragen.

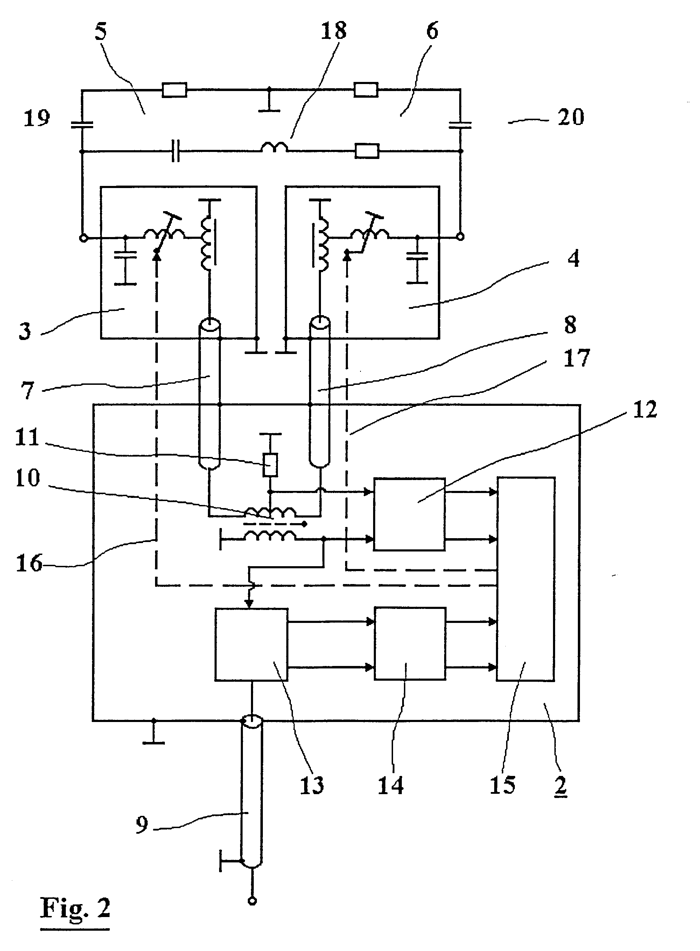

Fig. 2 zeigt das Antennenanpaßgerät 2 als detailliertes Blockschaltbild und in der Form von elektrischen Ersatzschaltbildern die Anpaßnetzwerke 3 und 4 sowie die aus den beiden Dipolhälften 5 und 6 bestehende Antenne.

Das Antennenanpaßgerät 2 besteht aus einem Eingang für die Ausgangsleitung 9 der Sender-Empfänger-Stufe 1, zwei Ausgängen für die Speiseleitungen 7 und 8 zu den Dipolhälften 5 und 6, einem Leistungsteiler 10, einem Symmetriesignalgeber 11, einem Reflexionssignalgeber 13, je einer Sensorik 12 und 14 für die beiden Signalgeber, einer CPU-Steuereinheit 15 und aus zwei Steuerleitungen 16 und 17 zur Ansteuerung der Anpaßnetzwerke 3 und 4.

Das Ersatzschaltbild der Antenne zeigt die zwischen den beiden Dipolhälften 5 und 6 wirkende Koppelimdedanz 18 und die Anschlußimpedanzen 19 und 20 der Dipolhälften 5 und 6. Die Abmessung der elektrischen Länge 1 jeder der Dipolhälften 5 und 6 ist in dem hier beschriebenen Ausführungsbeispiel kleiner als 1 % der Wellenlänge.

In dem hier gezeigten Ausführungsbeispiel ist der Reflexionssignalgeber 13 in üblicher Weise als Richtkoppler ausgeführt, mit dem die Vor- und die Rücklaufspannung auf der Ausgangsleitung 9 abgegriffen sind. In der zugehörigen Sensorik 14 ist aus diesen Meßwerten die Phase zwischen den beiden Spannungen gebildet. Zusammen mit den aufbereiteten Meßwerten für die Vor-und Rücklaufspannung wird der aufbereitete Meßwert für die Phase auf die CPU-Steuereinheit 15 gegeben, in der aus diesen Meßwerten nach bekannten Zusammenhängen ein Augenblickswert für das Reflexionsverhältnis auf der Ausgangsleitung 9 gebildet ist.

Als Symmetriesignalgeber 11 ist hier im Zusammenhang mit dem als Transformatorteiler ausgebildeten Leistungsteiler ein ohmscher Widerstand eingesetzt. Dieser Widerstand ist zwischen dem sekundärseitigen Mittelpunktabgriff des Transformatorteilers und der Masse eingefügt und es fällt bei Unsymmetrie eine Differenzspannung der beiden an den Eingängen der Speiseleitungen 7 und 8 anstehenden Teilspannungen über ihn ab. Diese Differenzspannung wird am Widerstand abgegriffen und der zugehörigen Sensorik 12 zugeführt. Weiterhin ist die Phase der Differenzspannung (positives oder negatives Vorzeichen) erfaßt, indem in der Sensorik 12 die Differenzspannung und die Primärspannung auf einen Komparator gegeben sind. Die aufbereiteten Meßwerte für die Differenzspannung und ihre Phase sind auf die CPU-Steuereinheit 15 zur Ansteuerung der Anpaßnetzwerke 3 und 4 gegeben.

An den Ausgang des Leistungsteilers 10 sind die beiden Speiseleitungen 7 und 8 angeschlossen in welche benachbart zu den Einspeisungspunkten der Dipolhälften 5 und 6 je eines der Anpaßnetzwerke 3 und 4 integriert ist. Die Anpaßnetzwerke 3 und 4 sind in üblicher, bekannter Weise aufgebaut und übereinstimmend ausgeführt. Sie werden von der CPU-Einheit 15 über je eine Steuerleitung 16 und 17 angesteuert.

In die CPU-Steuereinheit 15 ist ein Algorithmus eingespeichert, mit dem dieCPU in Abhängigkeit von den ihr zugeführten Meßwerten iterativ Steuersignalwerte für die Anpaßnetzwerke 3 und 4 errechnet. Der Algorithmus kann erfindungsgemäß so aufgebaut sein, daß die iterative Anpassung in zwei aufeinanderfolgenden Phasen abläuft. Zunächst wird in einer ersten Phase die auf der Ausgangsleitung 9 herrschende Reflexion auf ein Minimum gesteuert, so daß der Reflexionskoeffizient Werte zwischen 0.1 und 0.2 annimmt. In einer zweiten Phase wird dann ein Minimum des Symmetriefehlers eingestellt, indem die an dem Symmetriesignalgeber 11 anfallende Differenzspannung iterativ gegen Null gesteuert wird. Erfindungsgemäß wird dabei das vorher eingestellte Reflexionsminimum aufrecht erhalten. Zur Einhaltung dieser Bedingung werden die Anpaßnetzwerke 3 und 4 erfindungsgemäß mit entgegengesetzt wirkenden Stellgrößen beaufschlagt. So lange das erreichete Reflexionsminimum aufrechterhalten ist, können diese entgegengesetzt wirkenden Stellgrößen gleiche Beträge aufweisen.

Zur Abkürzung des in der zweiten Phase ablaufenden Iterationsverfahrens wird in dem hier beschriebenen Ausführungsbeispiel für die Ermittlung der Stellgrößen die Phase der Differenzspannung berücksichtigt.

Der Algorithmus kann alternativ auch so ausgebildet sein, daß die Einstellung des Refelexionsminimums und des Minimums des Symmetriefhlers von anfang an gleichzeitig in einer gemeinsamen Iterationsphase abläuft.

## Patentansprüche

1. Antennenanpaßgerät zur Anpassung der Antennenimpedanz von mindestens einem Kurzwellendipol an den Lastwiderstand einer Sender-Empfänger-Stufe mittels mindestens einem in die Speiseleitung integrierten, steuerbaren Anpaßnetzwerk,
dadurch gekennzeichnet,
- daß der Kurzwellendipol aus zwei Dipolhälften (5, 6) mit getrennten Speisestellen besteht;
- daß an jeder Speisestelle der Dipolhälften (5, 6) je ein Anpaßnetzwerk (3,4) in die Speiseleitung (7,8) integriert ist;
- daß die Ausgangsleitung (9) der Sender-Empfänger-Stufe (1) über einen Leistungsteiler (10) mit den beiden Speiseleitungen (7,8) verbunden ist;
- daß in die Ausgangsleitung (9) der Sender-Empfänger-Stufe (1) ein Reflexionssignalgeber (13) integriert ist, dessen Signale auf eine CPU-Steuereinheit (15) zur Ermittlung des Relexionskoeffizienten gegeben sind;
- daß mittels eines Symmetriesignalgebers (11) die Differenzspannung der Speiseleitungen (7, 8) gebildet und zusammen mit der Phase dieser Differenzspannung der CPU-Steuereinheit (15) zugeleitet ist;
- daß die Anpaßnetzwerke (3, 4) von der CPU-Steuereinheit (15) nach einem Algorithmus der Steuereinheit in Abhängigkeit von den Meßwerten iterativ so gesteuert sind, daß der Reflexionskoeffizient minimale Werte annimmt und unter Beibehaltung des erreichten Reflexionsminimums durch eine entgegengesetzt wirkende Ansteuerung der Anpaßnetzwerke (3, 4) ein Minimum des Symmetriefehlers eingestellt ist.

2. Antennenanpaßgerät nach Anspruch 1, dadurch gekennzeichnet, daß der in der CPU-Steuereinheit (15) wirkende Algorithmus so ausgebildet ist, daß ein vorgegebenes Reflexionsminimum in einer ersten Phase eingestellt ist und daran anschließend in einer zweiten Phase die Einstellung des Minimum des Symmetriefehlers unter Beibehaltung dieses Reflexionsminimums durchgeführt ist.

3. Antennenanpaßgerät nach Anspruch 1 oder 2, dadurch gekennzeichnet, daß die Einstellung des Minimums des Symmetriefehlers unter Berücksichtigung der Phase der Differenzspannung des Symmetriesignalgebers (11) eingeleitet ist.

## Claims

1. Antenna matching apparatus for matching antenna impedance of at least one shortwave dipole to the load resistance of a transmitter-receiver stage by means of at least one controllable matching network integrated in the feed line, characterised thereby
- that the shortwave dipole consists of two dipole halves (5, 6) with separate feed points;
- that a respective matching network (3, 4) is integrated in the feed line (7, 8) at each feed point of the dipole halves (5, 6);
- that the output line (9) of the transmitter-receiver stage (1) is connected with the two feed lines (7, 8) by way of a power divider (10);
- that a reflection signal transmitter (13), the signals of which are fed to a CPU control unit (15) for ascertaining the reflection coefficients, is integrated in the output line (9) of the transmitter-receiver stage (1);
- that the difference voltage of the feed lines (7, 8) is formed by means of a symmetrical signal transmitter (11) and fed to the CPU control unit (15) together with the phase of this difference voltage;
- that the matching networks (3, 4) are so iteratively controlled by the CPU control unit (15) according to an algorithm of the control unit in dependence on the measurement values that the reflection coefficient adopts minimum values and a minimum of the symmetry error is set by an oppositely acting drive control of the matching works (3, 4) whilst maintaining the attained reflection minimum.

2. Antenna matching apparatus according to claim 1, characterised thereby that the algorithm acting in the CPU control unit (15) is so formed that a preset reflection minimum is set in a first phase and subsequently thereto the setting of the minimum of the symmetry error is undertaken in a second phase whilst maintaining this reflection minimum.

3. Antenna matching apparatus according to claim 1 or 2, characterised thereby that the setting of the minimum of the symmetry error is initiated with consideration of the phase of the difference voltage of symmetry signal transmitter (11).

## Revendications

1. Circuit d'adaptation d'antenne pour l'adaptation d'impédance d'antenne d'au moins un dipôle d'ondes courtes à la résistance de charge d'un étage émetteur-récepteur au moyen d'au moins un réseau d'adaptation que l'on peut commander, intégré dans la ligne d'alimentation,
caractérisé par le fait,
- que le dipôle pour ondes courtes est constitué de deux demi-dipôles (6, 6) à points d'alimentation distincts;
- qu'à chaque point d'alimentation des demi-dipôles (5, 6) est intégré dans la ligne d'alimentation (7, 8) un réseau d'adaptation (3, 4);
- que la ligne de sortie (9) de l'étage émetteur-récepteur (1) est reliée aux deux lignes d'alimentation (7, 8) par l'intermédiaire d'un diviseur de puissance (10);
- que sur la ligne de sortie (9) de l'étage émetteur-récepteur (1) est intégré un émetteur du signal de réflexion (13) dont les signaux sont envoyés à une unité centrale de commande CPU (15) pour déterminer le coefficient de réflexion;
- qu'au moyen d'un émetteur du signal d'équilibrage (11) est formée la différence de tension des lignes d'alimentation (7, 8) qui est envoyée à l'unité centrale de commande CPU (15) en même temps que la phase de cette différence de tension;
- que les réseaux d'adaptation (3, 4) sont commandés, par l'unité centrale de commande CPU (15), d'après un algorithme de l'unité de commande et en fonction des valeurs de mesure, en mode itératif de façon que les coefficients de réflexion prennent des valeurs minimales et que tout en conservant les minimums de réflexion obtenus, un minimum de l'erreur d'équilibrage soit prescrit par une commande, agissant en sens opposé, des réseaux d'adaptation (3, 4).

2. Circuit d'adaptation d'antenne selon la revendication 1, caractérisé par le fait que l'algorithme agissant dans l'unité centrale de commande CPU (15) est conçu de façon que dans une première phase soit prescrit un minimum de réflexion donné et qu'ensuite dans une seconde phase il soit procédé à la prescription du minimum de l'erreur de l'équilibrage tout en conservant ce minimum de réflexion.

3. Circuit d'adaptation d'antenne selon la revendication 1 ou la revendication 2, caractérisé par le fait que la prescription du minimum de l'erreur d'équilibrage se fait en tenant compte de la phase de la différence de tension de l'émetteur du signal d'équilibrage (11).
